# EUROPÄISCHE PATENTSCHRIFT

(11) **EP 3 745 147 B1**
(45) Veröffentlichungstag und Bekanntmachung des Hinweises auf die Patenterteilung: **05.03.2025**
(21) Anmeldenummer: 20174368.9
(22) Anmeldetag: 13.05.2020
(51) Int. Cl.: G01R 31/28, H02H 3/04, H02H 1/00

(54) **SCHUTZVORRICHTUNG FÜR EINEN STROMKREIS MIT MITTELN ZUR FERNDIAGNOSE**
SAFETY DEVICE FOR A POWER CIRCUIT WITH MEANS FOR REMOTE DIAGNOSIS
DISPOSITIF DE PROTECTION POUR UN CIRCUIT AVEC DES MOYENS DE DIAGNOSTIC À DISTANCE

(30) Priorität: 27.05.2019 AT 5008819 U
(43) Veröffentlichungstag der Anmeldung: 02.12.2020
(73) Patentinhaber: Sprecher Automation GmbH, 4020 Linz (AT)
(72) Erfinder: Meindl, Johann, 4300 St. Valentin (AT)
(74) Vertreter: Hübscher & Partner Patentanwälte GmbH

(56) Entgegenhaltungen:
- EP-A1- 2 770 597
- WO-A1-2007/079702
- US-A1- 2008 183 406

## Beschreibung

Die Erfindung bezieht sich auf eine Schutzvorrichtung für einen Stromkreis, die eine Auslöseeinheit mit einem Signaleingang für Signaldatensätze analog/digital gewandelter, Betriebsgrößen entsprechender Signale und einen von der Auslöseeinheit in Abhängigkeit der Signaldatensätze mit einem Steuersignal beaufschlagten Steuerausgang für einen Schutzaktor aufweist.

Zur Prüfung der korrekten Funktion von Schutzgeräten wie beispielsweise Schutzrelais ist es bekannt, vor Ort Schutzprüfgeräte mit den jeweiligen Signaleingängen des Schutzgerätes zu verbinden und auf diese Weise Signale von fehlerfreien und fehlerbehafteten Betriebszuständen nachzubilden. Nachteilig ist allerdings, dass zur Vorbereitung, Durchführung und Überwachung des Prüfvorganges immer eine Bedienperson vor Ort anwesend sein muss, wodurch sich solche Prüfverfahren als äußerst zeitaufwändig gestalten. Darüber hinaus müssen zur Prüfung die überwachten Teile des Stromkreises von dem Schutzgerät getrennt werden, um einerseits die Prüfsignale anlegen zu können und um andererseits eine Auslösung eines Schutzaktors aufgrund der Prüfsignale zu verhindern.

Aufgrund der zunehmenden Digitalisierung ist es bekannt, die Signale von Messstellen für Betriebsgrößen analog/digital zu wandeln und über einen gemeinsamen Prozessbus den Schutzvorrichtungen zur Verfügung zu stellen. Hierbei können mithilfe eines Prüfgerätes erzeugte Datenstreams, die verschiedene Strom- und Spannungswerte in digitaler Form abbilden, der Schutzvorrichtung über den Prozessbus übermittelt werden. Auf Basis des übermittelten Datenstreams wird die Schutzvorrichtung auf ihre korrekte Funktion zufolge der einen jeweiligen Betriebszustand darstellenden Strom- und Spannungswertabbildungen überprüft. Allerdings ist auch bei solchen Prüfverfahren eine Bedienperson vor Ort notwendig, die ein digitales Prüfgerät mit dem Prozessbus der Schutzvorrichtung verbinden muss, während der normale Prozessbetrieb unterbrochen wird, weil die Nachbildung des korrekten zeitlichen Ablaufs der Signale und deren Analog/Digital-Wandlung durch etwaige Laufzeitschwankungen bei der Einspeisung beeinträchtigt wird. Reproduzierbare Prüfergebnisse sind damit nur mit großem Aufwand erreichbar.

Aus WO2007079702 A1 ist ein Verfahren zum Testen eines digitale Abtastdaten verarbeitenden Schutzgeräts bekannt. Hierbei wird eine abgespeicherte Störwertaufzeichnung (DU, DI) zumindest eines Wandlers in eine Prüfeinrichtung (50) geladen, mit den Daten der Störwertaufzeichnung werden digitale Abtastwerte gebildet, die den von dem Wandler während der Störwertaufzeichnung aufgenommenen Wandlerdaten entsprechen, die gebildeten digitalen Abtastwerte werden in digitale netzwerkkompatible Datenpakete (Dtest) eingebettet , die netzwerkkompatiblen Datenpakete (Dtest) werden zu einer netzwerkkompatiblen Schnittstelle (D60) des Schutzgeräts (60) übertragen und die Reaktion des Schutzgeräts auf die übertragenen digitalen Abtastwerte wird ausgewertet.

Der Erfindung liegt somit die Aufgabe zugrunde, eine Schutzvorrichtung der eingangs geschilderten Art so auszugestalten, dass eine zuverlässige und zeiteffiziente Fernprüfung der Schutzvorrichtung ermöglicht wird, ohne dass es zu Unterbrechungen des Prozessbetriebes kommt.

Die Erfindung löst die gestellte Aufgabe dadurch, dass die Schutzvorrichtung eine mit einer Prüfeinheit verbundene Prüfschnittstelle zur Eingabe von Prüfsignalpaketen und zur Ausgabe von Protokolldatenpaketen aufweist, dass die Prüfeinheit mit der Auslöseeinheit zur Eingabe von Prüfsignaldatensätzen verbunden ist und dass die Prüfeinheit ein mit der Auslöseeinheit verbundenes Aufzeichnungsmodul zum Speichern der Protokolldatensätze in Protokolldatenpaketen umfasst.

Durch die vom Signaleingang unabhängige Übermittlung von Prüfsignalpaketen, also mehreren, zu einem Paket zusammengefassten Prüfsignaldatensätzen kann eine Trennung der Schutzvorrichtung von der Quelle der analog/digital gewandelten Betriebsgrößen unterbleiben und das Übertragen der Prüfsignaldatensätze aus dem Prüfsignalpaket von der Prüfeinheit an die Auslöseeinheit kann mit einer vorgegebenen Taktrate innerhalb der Schutzvorrichtung erfolgen, sodass etwaige Laufzeitschwankungen bei der Übertragung der Prüfsignalpakete keinen Einfluss auf die Prüfung haben. Umgekehrt kann durch die Aufzeichnung der von der Auslöseeinheit ausgegebenen Protokolldatensätze innerhalb der Schutzvorrichtung die externe Verbindung zu Schutzaktoren grundsätzlich bestehen bleiben, wenn der Steuerausgang deaktiviert oder die Ausgabe eines Steuersignals in einem Prüfmodus der Auslöseeinheit unterbrochen wird. Erfolgt die Aufzeichnung der Protokolldatensätze zu einem Protokolldatenpaket ebenfalls in der vorgegebenen Taktrate, kann eine unmittelbare Zuordnung der Prüfsignaldatensätze aus dem Prüfsignalpaket zu den Protokolldatensätzen des Protokolldatenpakets vorgenommen werden, sodass wiederholbare Prüfbedingungen geschaffen werden. Die Analog/Digital-Wandlung der Betriebsgrößen kann dabei entweder innerhalb der Schutzvorrichtung selbst oder aber auch außerhalb der Schutzvorrichtung mithilfe eines externen Analog/Digital-Wandlers erfolgen, wobei die Übertragung der Signaldatensätze an die Auslöseeinheit beispielsweise über einen Prozessbus erfolgen kann. Durch die gesonderte Prüfschnittstelle und die Unabhängigkeit von etwaigen Laufzeitschwankungen kann zufolge der erfindungsgemäßen Maßnahmen auch eine Fernprüfung vorgenommen werden, ohne dass eine Bedienperson vor Ort sein müsste. Auch die simultane Prüfung mehrerer Schutzvorrichtungen wird somit in einfacher Weise ermöglicht.

Obwohl die Auslöseeinheit grundsätzlich nur einen umschaltbaren Signaleingang, der entweder mit dem Signaleingang der Schutzvorrichtung oder mit dem Prüfsignalausgang der Prüfeinheit verbunden wird und / oder nur einen umschaltbaren Steuerausgang, der entweder mit dem Steuerausgang der Schutzvorrichtung oder dem Protokollsignaleingang der Prüfeinheit verbunden wird, aufweisen kann, ergeben sich besonders günstige Prüfbedingungen, wenn die Auslöseeinheit einen vom Signaleingang getrennten Prüfsignaleingang zur Eingabe von Prüfsignaldatensätzen und/oder einen vom Steuerausgang getrennten Protokollsignalausgang zur Ausgabe von Protokolldatensätzen aufweist. Zufolge dieser Maßnahmen kann über die getrennten Prüfsignaleingänge bzw. Protokollsignalausgänge eine vom Normalbetrieb völlig unabhängige Prüfung durchgeführt werden, solange sichergestellt ist, dass sowohl der Signaleingang für den Normalbetrieb als auch der Prüfsignaleingang der gleichen Auslöselogik zugeführt wird. Bei einem getrennten Protokollsignalausgang kann einerseits der Prüfsignaleingang nur den Protokollsignalausgang beeinflussen, während der Signaleingang für den Normalbetrieb nur den Steuerausgang beeinflusst und andererseits können über den Protokollsignalausgang zusätzliche Prüfinformationen, beispielsweise im Fehlerfall, ausgegeben werden, die eine Diagnose erleichtern.

Um die gerade bei transienten Betriebszuständen auftretenden, hochdynamischen Signalverläufe korrekt abbilden zu können, kann die Prüfeinheit mit einem Systemtaktgeber zur synchronisierten Übertragung von Prüfsignaldatensätzen eines Prüfsignalpaketes an die Auslöseeinheit verbunden sein. Dieser Systemtaktgeber kann beispielsweise von einem über den Prozessbus vorgegebenen Systemtakt gespeist werden.

Bei Schutzvorrichtungen ist neben einer ordnungsgemäßen Funktion der Auslöselogik auch eine korrekte Konfiguration der Betriebsparameter für einen zuverlässigen Betrieb entscheidend. Beispielsweise ist bei Schutzrelais die korrekte Vorgabe von primär- und sekundärseitigen Übersetzungsverhältnissen von Messwandlern erforderlich. Um solche Betriebsparameter bei einer Überprüfung ebenfalls berücksichtigen zu können, wird vorgeschlagen, dass sowohl die Auslöseeinheit als auch die Prüfeinheit mit einem Parameterspeicher verbunden sind. Auf diese Weise kann vor dem Anlegen der Prüfsignaldatensätze an die Auslöseeinheit ein entsprechender Parametersatz in den Parameterspeicher geschrieben oder aber der im Parameterspeicher vorhandene Parametersatz auf Plausibilität geprüft werden.

Um mehrere erfindungsgemäße Schutzvorrichtungen gemeinsam überprüfen zu können bzw. um solche Prüfungen in einem Stromkreis aufeinander abstimmen und automatisieren zu können, wird vorgeschlagen, dass die Prüfschnittstelle mit einem Prüfbus verbunden ist. Dieser Prüfbus kann im Gegensatz zum Prozessbus geringeren Echtzeitanforderungen genügen und bei geeigneten Sicherheitsmaßnahmen auch an andere Übertragungsmedien angeschlossen werden.

Die Erfindung bezieht sich auch auf ein Verfahren zur Prüfung einer erfindungsgemäßen Schutzvorrichtung, wobei ein Prüfsignalpaket über die Prüfschnittstelle an die Prüfeinheit übermittelt wird, die einzelne Prüfsignaldatensätze des Prüfsignalpaketes an die Auslöseeinheit übergibt und die von der Auslöseeinheit ausgegebenen Protokolldatensätze zu einem Protokolldatenpaket aufzeichnet, wobei die Übermittlung der Prüfsignaldatensätze und die Aufzeichnung der Protokolldatensätze im Systemtakt der Auslöseeinheit erfolgt. Nach der Durchführung der Prüfung kann das Protokolldatenpaket entweder automatisiert über die Prüfschnittstelle ausgegeben oder über die Prüfschnittstelle abgerufen werden.

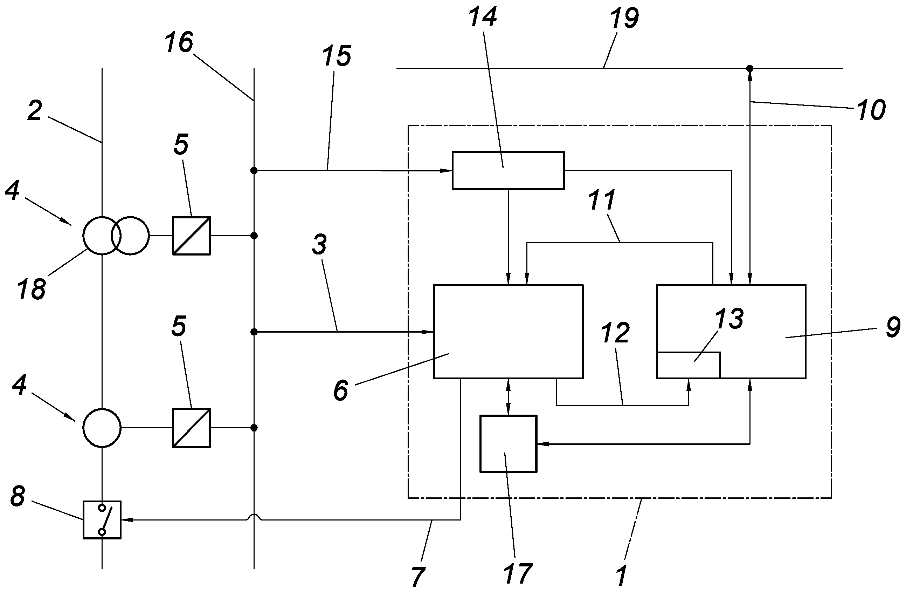

In der Zeichnung ist der Erfindungsgegenstand beispielsweise dargestellt, und zwar in einem schematischen Blockschaltbild.

Eine erfindungsgemäße Schutzvorrichtung 1 für einen Stromkreis 2 weist einen Signaleingang 3 auf, über den Betriebsgrößen entsprechende Signale von Messstellen 4, wie beispielsweise Strom oder Spannung, die über Analog/Digital-Wandler 5 in Signaldatensätze umgewandelt wurden an eine Auslöseeinheit 6 übergeben werden. Entsprechend einer Auslöselogik gibt die Auslöseeinheit 6 ein Steuersignal aus, das über einen Steuerausgang 7 einem Schutzaktor 8, wie beispielsweise einem Relais zugeleitet wird. Die Schutzvorrichtung 1 umfasst darüber hinaus eine Prüfeinheit 9, die mit einer Prüfschnittstelle 10 verbunden ist. Über diese Prüfschnittstelle 10 können Prüfsignalpakete an die Prüfeinheit 9 übertragen oder Protokolldatenpakete von der Prüfeinheit 9 abgerufen werden.

Zur Überprüfung der korrekten Funktion der Auslöseeinheit 6 ist diese über einen Prüfsignaleingang 11 mit einem Prüfsignalausgang der Prüfeinheit 9 verbunden, über den einzelne Prüfsignaldatensätze eines über die Prüfschnittstelle 10 übertragenen Prüfsignalpaketes übertragen werden, und zwar in einer vorgegebenen Taktrate, vorzugsweise in der Taktrate der Auslöseeinheit 6 selbst bzw. in der Taktrate der Signaldatensätze, die über den Signaleingang 3 übergeben werden. Gleichzeitig weist die Auslöseeinheit 6 einen Protokollsignalausgang 12 zur Ausgabe von Protokolldatensätzen auf. Dieser Protokollsignalausgang 12 ist mit einem Aufzeichnungsmodul 13 der Prüfeinheit 9 verbunden, das die einzelnen Protokolldatensätze zu einem Protokolldatenpaket zusammenfasst und abspeichert.

In einer besonders bevorzugten Ausführungsform wird das Ergebnis der Auswertung der über den Prüfsignaleingang 11 übertragenen Prüfsignaldatensätze ausschließlich über den Protokollsignalausgang 12 ausgegeben, während das Ergebnis der Auswertung der über den Signaleingang 3 übertragenen Signaldatensätze ausschließlich über den Steuerausgang 7 ausgegeben wird. In einer nicht näher dargestellten alternativen Ausführungsform können der Signaleingang 3 und der Prüfsignaleingang 11 und / oder der Steuerausgang 7 und der Protokollsignalausgang 12 umgeschaltet oder wechselweise deaktiviert werden.

Für die Auslöseeinheit 6 und die Prüfeinheit 9 kann ein gemeinsamer Systemtaktgeber 14 vorgesehen sein, der über einen Taktsignaleingang 15 mit einem Prozessbus 16 verbunden ist, über den beispielsweise auch die Signaldatensätze von den Analog/Digital-Wandlern 5 an den Signaleingang 3 übertragen werden.

Zur Vorgabe und Überprüfung von Parametersätzen kann ein Parameterspeicher 17 vorgesehen sein, der sowohl mit der Auslöseeinheit 6 als auch mit der Prüfeinheit 9 verbunden ist. Solche Parametersätze können beispielsweise das Übersetzungsverhältnis eines Messwandlers 18 beinhalten.

Zur Fernüberprüfung einer oder mehrerer Schutzvorrichtungen kann die Prüfschnittstelle 10 mit einem Prüfbus 19 verbunden werden.

## Patentansprüche

1. Schutzvorrichtung (1) für einen Stromkreis (2), die eine Auslöseeinheit (6) mit einem Signaleingang (3) für Signaldatensätze analog/digital gewandelter, Betriebsgrößen entsprechender Signale und einen von der Auslöseeinheit (6) in Abhängigkeit der Signaldatensätze mit einem Steuersignal beaufschlagten Steuerausgang (7) für einen Schutzaktor (8) wobei die Schutzvorrichtung (1) eine Prüfeinheit (9) sowie eine mit der Prüfeinheit (9) verbundene Prüfschnittstelle (10) zur Eingabe von Prüfsignalpaketen und zur Ausgabe von Protokolldatenpaketen aufweist, und die Prüfeinheit (9) mit der Auslöseeinheit (6) zur Eingabe von Prüfsignaldatensätzen verbunden ist, **dadurch gekennzeichnet, dass** die Prüfeinheit (9) ein mit der Auslöseeinheit (6) verbundenes Aufzeichnungsmodul (13) zum Speichern von Protokolldatensätzen in Protokolldatenpaketen umfasst.

2. Schutzvorrichtung nach Anspruch 1, **dadurch gekennzeichnet, dass** die Auslöseeinheit (6) einen vom Signaleingang (3) getrennten Prüfsignaleingang (11) zur Eingabe von Prüfsignaldatensätzen und/oder einen vom Steuerausgang (7) getrennten Protokollsignalausgang (12) zur Ausgabe von Protokolldatensätzen aufweist.

3. Schutzvorrichtung nach Anspruch 1 oder 2, **dadurch gekennzeichnet, dass** die Prüfeinheit (9) mit einem Systemtaktgeber (14) zur synchronisierten Übertragung von Prüfsignaldatensätzen eines Prüfsignalpaketes an die Auslöseeinheit (6) verbunden ist.

4. Schutzvorrichtung nach einem der Ansprüche 1 bis 3, **dadurch gekennzeichnet, dass** sowohl die Auslöseeinheit (6) als auch die Prüfeinheit (9) mit einem Parameterspeicher (17) verbunden sind.

5. Schutzvorrichtung nach einem der Ansprüche 1 bis 4, **dadurch gekennzeichnet, dass** die Prüfschnittstelle (10) mit einem Prüfbus (19) verbunden ist.

6. Verfahren zur Prüfung einer Schutzvorrichtung (1) nach einem der vorangegangenen Ansprüche, **dadurch gekennzeichnet, dass** ein Prüfsignalpaket über die Prüfschnittstelle (10) an die Prüfeinheit (9) übermittelt wird, die einzelne Prüfsignaldatensätze des Prüfsignalpaketes an die Auslöseeinheit (6) übergibt und die von der Auslöseeinheit (6) ausgegebenen Protokolldatensätze zu einem Protokolldatenpaket aufzeichnet, wobei die Übermittlung der Prüfsignaldatensätze und die Aufzeichnung der Protokolldatensätze im Systemtakt der Auslöseeinheit (6) erfolgt.

## Claims

1. Protective device (1) for a circuit (2), which has a trigger unit (6) with a signal input (3) for signal data sets of analog/digitally converted signals corresponding to operating variables, and a control output (7) for a protective actuator (8), which control output (7) is applied with a control signal by the trigger unit (6) in dependence of the signal data sets, wherein the protective device (1) has a test unit (9) and a test interface (10) connected to the test unit (9) for the input of test signal packets and for the output of protocol data packets and wherein the test unit (9) is connected to the trigger unit (6) for inputting test signal data sets, **characterized in that** the test unit (9) comprises a recording module (13) connected to the trigger unit (6) for storing protocol data sets in protocol data packets.

2. Protective device according to claim 1, **characterized in that** the trigger unit (6) has a test signal input (11), which is separate from the signal input (3), for inputting test signal data sets and/or a protocol signal output (12), which is separate from the control output (7), for outputting protocol data sets.

3. Protective device according to claim 1 or 2, **characterized in that** the test unit (9) is connected to a system clock (14) for synchronized transmission of test signal data sets of a test signal packet to the trigger unit (6).

4. Protective device according to one of claims 1 to 3, **characterized in that** both the trigger unit (6) and the test unit (9) are connected to a parameter memory (17).

5. Protective device according to one of claims 1 to 4, **characterized in that** the test interface (10) is connected to a test bus (19).

6. Method for testing a protective device (1) according to one of the preceding claims, **characterized in that** a test signal packet is transmitted to the test unit (9) via the test interface (10), which transmits individual test signal data sets of the test signal packet to the trigger unit (6) and records the protocol data sets output by the trigger unit (6) to form a protocol data packet, wherein the transmission of the test signal data sets and the recording of the protocol data sets is done according to the system clock of the trigger unit (6).

## Revendications

1. Dispositif de protection (1) pour un circuit (2), lequel présente une unité de déclenchement (6) avec une entrée de signaux (3) pour des signaux correspondant à des grandeurs de fonctionnement convertis de manière analogique/numérique en ensembles de données de signaux et une sortie de commande (7) pour un actionneur de protection (8) sollicitée par l'unité de déclenchement (6) en fonction des ensembles de données de signaux à l'aide d'un signal de commande, dans lequel le dispositif de protection (1) présente une unité de contrôle (9) ainsi qu'une interface de contrôle (10) reliée à l'unité de contrôle (9) pour entrer des paquets de signaux de contrôle et pour sortir des paquets de données de protocole, et l'unité de contrôle (9) est reliée à l'unité de déclenchement (6) pour entrer des ensembles de données de signaux de contrôle, **caractérisé en ce que** l'unité de contrôle (9) comprend un module d'enregistrement (13) relié à l'unité de déclenchement (6) pour mémoriser des ensembles de données de protocole dans des paquets de données de protocole.

2. Dispositif de protection selon la revendication 1, **caractérisé en ce que** l'unité de déclenchement (6) présente une entrée de signaux de contrôle (11) séparée de l'entrée de signaux (3) pour entrer des ensembles de données de signaux de contrôle et/ou une sortie de signaux de protocole (12) séparée de la sortie de commande (7) pour sortir des ensembles de données de protocole.

3. Dispositif de protection selon la revendication 1 ou 2, **caractérisé en ce que** l'unité de contrôle (9) est reliée à une horloge système (14) pour transmettre de manière synchronisée à l'unité de déclenchement (6) des ensembles de données de signaux de contrôle d'un paquet de signaux de contrôle.

4. Dispositif de protection selon une des revendications 1 à 3, **caractérisé en ce qu'**aussi bien l'unité de déclenchement (6) que l'unité de contrôle (9) sont reliées à une mémoire de paramètres (17).

5. Dispositif de protection selon une des revendications 1 à 4, **caractérisé en ce que** l'interface de contrôle (10) est reliée à un bus de contrôle (19).

6. Procédé destiné à contrôler un dispositif de protection (1) selon une des revendications précédentes, **caractérisé en ce qu'**un paquet de signaux de contrôle est transmis par le biais de l'interface de contrôle (10) à l'unité de contrôle (9) qui transmet les ensembles de données de signaux de contrôle individuels du paquet de signaux de contrôle à l'unité de déclenchement (6) et qui enregistre les ensembles de données de protocole sortis par l'unité de déclenchement (6) dans un paquet de données de protocole, dans lequel la transmission des ensembles de données de signaux de contrôle et l'enregistrement des ensembles de données de protocole se font dans l'horloge système de l'unité de déclenchement (6).
